# EUROPEAN PATENT APPLICATION

(11) **EP 2 723 152 A2**
(43) Date of publication of application: **23.04.2014**
(21) Application number: 13186344.1
(22) Date of filing: 27.09.2013
(51) Int. Cl.: H05K 7/20

(54) **Apparatus equipped with heat sink**

(30) Priority: 19.10.2012 JP 2012232142
(71) Applicant: OMRON CORPORATION, Kyoto-shi, Kyoto 600-8530 (JP)
(72) Inventor: Akamoto, Keigo, Kyoto-shi, Kyoto 600-8530 (JP); Takashiro, Hiroto, Kyoto-shi, Kyoto 600-8530 (JP); Ohashi, Shinsuke, Kyoto-shi, Kyoto 600-8530 (JP)
(74) Representative: Kilian Kilian & Partner

(57) **Abstract**

An apparatus is provided, the apparatus comprising: a casing (100); a heat sink (150) configured to radiate heat emitted from the casing (100); and a fixing plate (200) configured to fix the heat sink (150) by holding the heat sink (150) between the fixing plate (200) and the casing (100).

## Description

### TECHNICAL FIELD

The present invention relates to an apparatus equipped with a heat sink.

### BACKGROUND ART

Conventionally, a female screw is formed in a heat sink, and the heat sink is fixed to a casing using the female screw (for example, refer to Japanese Unexamined Patent Publication No. 2011-258874).

In many cases, a heat sink is made from a soft material such as aluminum. Therefore, the female screw formed in the heat sink is likely to have insufficient strength.

### SUMMARY

An apparatus according to one aspect of the present invention comprises a casing, a heat sink configured to radiate heat emitted from the casing, and a fixing plate configured to fix the heat sink by holding the heat sink between the fixing plate and the casing.

In the apparatus, the heat sink may include a radiation fin portion and a fixed portion, and the fixing plate may fix the heat sink by holding the fixed portion between the fixing plate and the casing. The fixing plate may have an opening through which a portion of the heat sink is exposed.

In the apparatus, the heat sink may have a radiation fin portion and a fixed portion, the fixing plate may have an opening through which a portion of the heat sink is exposed, the fixing plate may fix the heat sink by holding the fixed portion between the casing and the fixing plate, and the radiation fin portion may protrude outward through the opening.

In the apparatus, the heat sink may have a radiation fin portion and a fixed portion, the fixing plate may fix the heat sink by holding the fixed portion between the casing and the fixing plate, and the radiation fin portion may protrude outward through the opening. In the apparatus, the heat sink may have a first through hole, and the heat sink may be held between the casing and the fixing plate by a screw member which is installed to pass through the first through hole.

In the apparatus, the casing may have a second through hole, the fixing plate may have a female screw, and the heat sink may be held between the casing and the fixing plate in a manner that a male screw which is the screw member is screwed into the female screw, passing through the second through hole and the first through hole from inside of the casing.

In the apparatus, the heat sink may be provided in a back surface of the casing, the casing may have a recessed portion in the corner between the back surface and a side surface adjacent to the back surface, and the fixing plate may have a bridge portion which extends across the recessed portion. In the apparatus, the fixing plate may have an apparatus-side latching member latched to an attachment plate disposed on the back surface of the apparatus, and the apparatus may be attached to the attachment plate in a manner that the apparatus-side latching member is latched to an attachment plate-side latching member provided in the attachment plate.

In the apparatus, the fixing plate may further comprise a pillar portion which stands on the back surface of the apparatus, the apparatus-side latching member may include a latching plate supported by the pillar portion, and the latching plate may be latched to the attachment plate-side latching member. In the apparatus, the pillar portion may include a plurality of pillar plates and the latching plate is supported by the plurality of pillar plates.

The outline of the invention which is described above does not enumerate all the features of the present invention. Sub-combinations of groups of these features can also fall within the scope of the present invention.

### BRIEF DESCRIPTION OF THE DRAWINGS

Fig. 1 is an exploded perspective view obtained by viewing a power conditioner from a back side;
Fig. 2 is an exploded perspective view obtained by viewing the power conditioner from a front side;
Fig. 3 is a perspective view obtained by viewing the power conditioner from the front side;
Fig. 4 is a perspective view obtained by viewing a fixing plate provided for the power conditioner from the front side;
Fig. 5 is a perspective view obtained by viewing the fixing plate provided for the power conditioner from the back side;
Fig. 6 is a perspective view obtained by viewing an attachment plate provided for the power conditioner from the front side; and
Fig. 7 is an enlarged perspective view obtained by viewing a recessed portion and a bridge portion from the back side.

### DETAILED DESCRIPTION

Hereinafter, although the present invention is described by referring to embodiments of the invention, the following embodiments do not limit the inventions defined by the claims. It is needless to say that not all combinations of features which are described in the embodiments are necessarily indispensable to solving means of the invention.

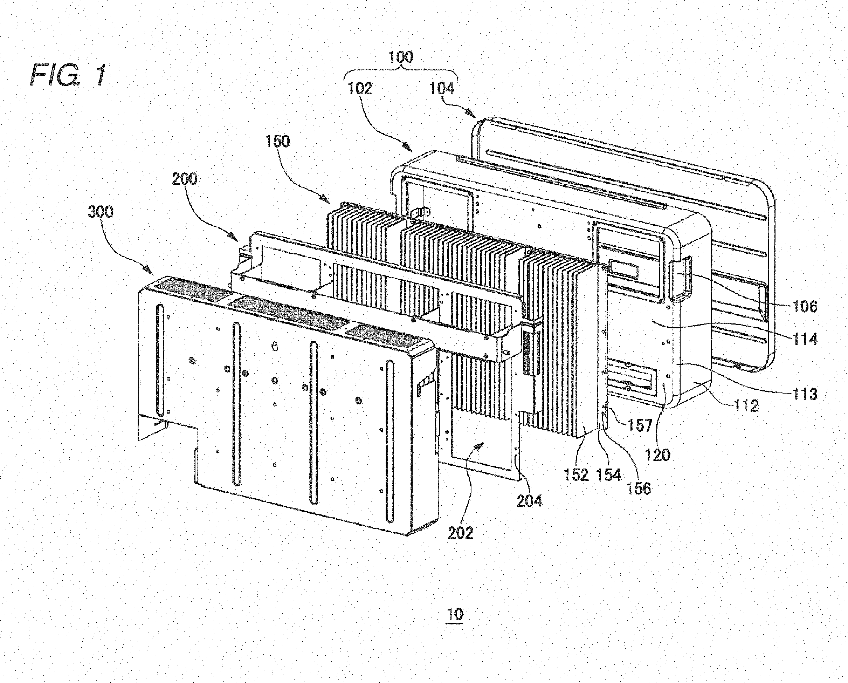

Fig. 1 is an exploded perspective view obtained by viewing a power conditioner 10 viewed from the back side. The power conditioner 10 converts direct current (DC) power output from a power source, such as a solar cell or a fuel cell, into alternating current (AC) power. The power conditioner 10 includes a casing 100, a heat sink 150, a fixing plate 200, and an attachment plate 300. The power conditioner 10 is fixed to an outer wall of a housing via the attachment plate 300. The power conditioner 10 is an example of an apparatus, such as an electronic device or an electric appliance.

The casing 100 includes an accommodation box 102 which has an opening in a front side, and a cover 104 which covers the opening of the accommodation box 102. The accommodation box 102 accommodates a first filter circuit, an inverter circuit, and a second filter circuit therein. The first filter circuit reduces noise of the DC power output from the power source. The inverter circuit converts DC power output from the first filter circuit into AC power. The second filter circuit reduces noise of the AC power output from the inverter.

The accommodation box 102 has a recessed portion 106, which is provided to allow user's hand to be inserted thereinto, in the corner 113 between a back surface 114 and a side surface 112 adjacent to the back surface 114. The recessed portion 106 for hand's insertion is used when a user carries the power conditioner 10.

The heat sink 150 is provided in the back surface 114. of the accommodation box 102. The heat sink 150 radiates heat generated by a heating element installed in the accommodation box 102. The heating element includes semiconductor devices like switching elements, diodes, etc. which constitute the first filter circuit, the inverter circuit, and the second filter circuit. The heat sink 150 includes a radiation fin portion 152, which is made up of a plurality of radiation fins, and a fixed portion 154 provided around the radiation fin portion 152.

The fixing plate 200 fixes the heat sink 150 by holding the heat sink 150 between the casing 100 and the fixing plate 200. The fixing plate 200 has an opening 202 through which a portion of the heat sink 150 is exposed. The fixing plate 200 fixes the heat sink 150 by holding the fixed portion 154 between the fixing plate 200 and the casing 100. In a state in which the fixed portion 154 is held between the fixing plate 200 and the casing 100, the radiation fin portion 152 protrudes outward through the opening 202.

The heat sink 150 has a plurality of through holes 156 in the fixed portion 154. The heat sink 150 further has a plurality of positioning holes 157 for enabling positioning with respect to the fixing plate 200. The casing 100 has a plurality of through holes 120 in positions corresponding to the plurality of through holes 156. The fixing plate 200 has a plurality of female screws 204 in positions corresponding to the plurality of through holes 156, respectively and the plurality of through holes 120, respectively. The through holes 156 and through holes 120 may be simple holes with no screw threads, or threaded holes with screw threads. The heat sink 150 is held between the casing 100 and the fixing plate 200 using screw members which are inserted into the through holes 156 and through holes 120. Specifically, the heat sink 150 is held between the casing 100 and the fixing plate 200 by screwing a male screw, which is a screw member, into the female screw 204 through the through hole 120 and the through hole 156 from the inner side of the casing 100.

Here, the fixing plate 200 and the female screw 204 are made from a harder material than the heat sink 150. The fixing plate 200 and the female screw 204 are made from a relatively hard material, such as iron, and the heat sink 150 is made from a relatively soft material, such as aluminum. Therefore, even when vibration or a shock is applied to the power conditioner 10, the fixing plate 200 and the female screw 204 may not be easily deformed. Since the heat sink 150 is not directly fixed by the male thread, deformation of the heat sink 150, which is mainly attributable to direct contact with the male thread, does not occur, even when vibration or a shock is applied to the power conditioner 10.

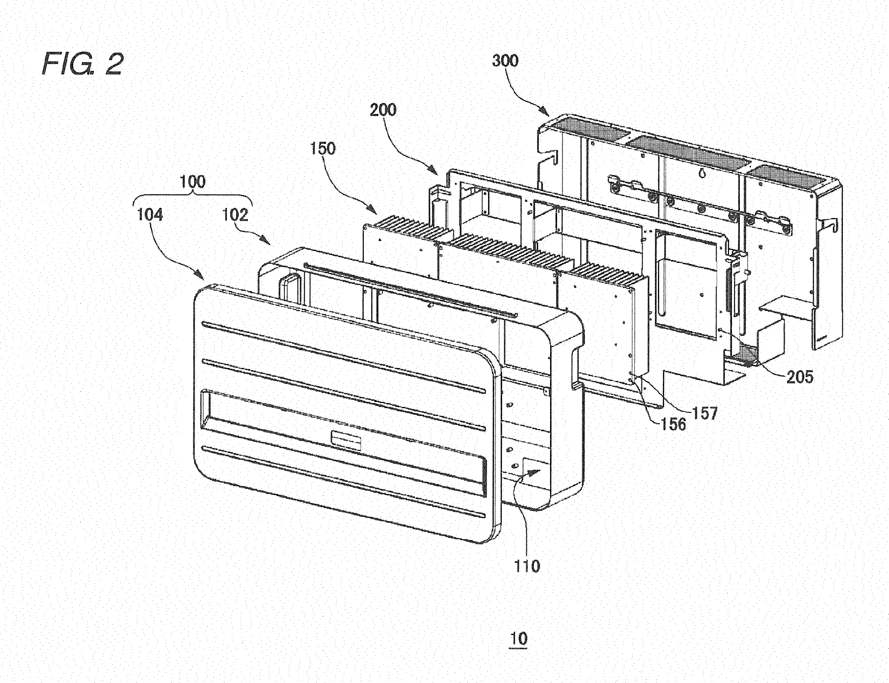

Fig. 2 is an exploded perspective view obtained by viewing the power conditioner 10 from the front side. The accommodation box 102 has an insertion hole 110, through which a cable can be inserted into the accommodation box 102, in the back surface. In a front surface of the fixing plate 200, a plurality of protrusions 205 are formed in positions corresponding to the positioning holes 157 formed in the heat sink 150. With this configuration, the heat sink 150 can be accurately positioned with respect to the fixing plate 200. Furthermore, even if vibration or a shock is applied to the power conditioner 10, the force attributable to the vibration or shock and exerted on the positioning holes 157 and the through holes 156 is distributed. Therefore, it is possible to suppress the positioning holes 157 and the through holes 156 from being deformed by vibration or a shock.

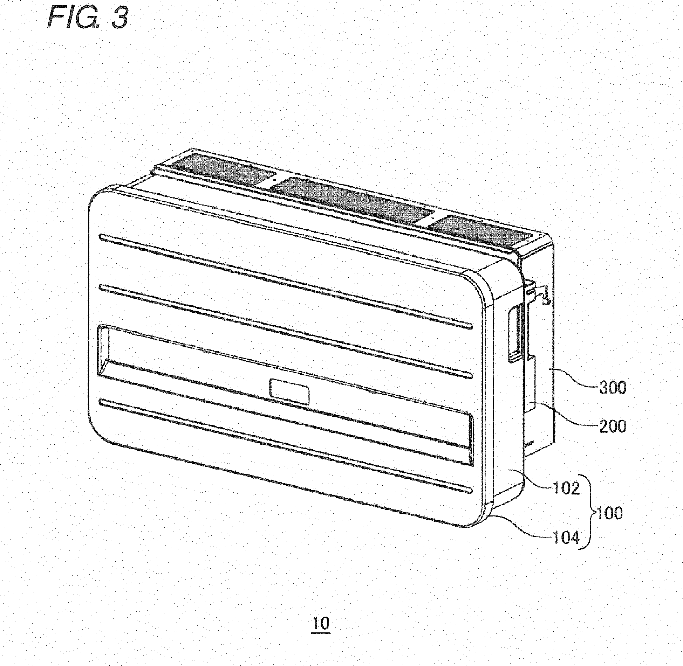

Fig. 3 is a perspective view obtained by viewing the power conditioner 10 from the front side. The fixing plate 200, the heat sink, the accommodation box 102, and the cover 104 are assembled in an arranged manner illustrated in Figs. 1 and 2. The casing 100 which holds the heat sink 150 between itself and the fixing plate 200 is attached to the attachment plate 300.

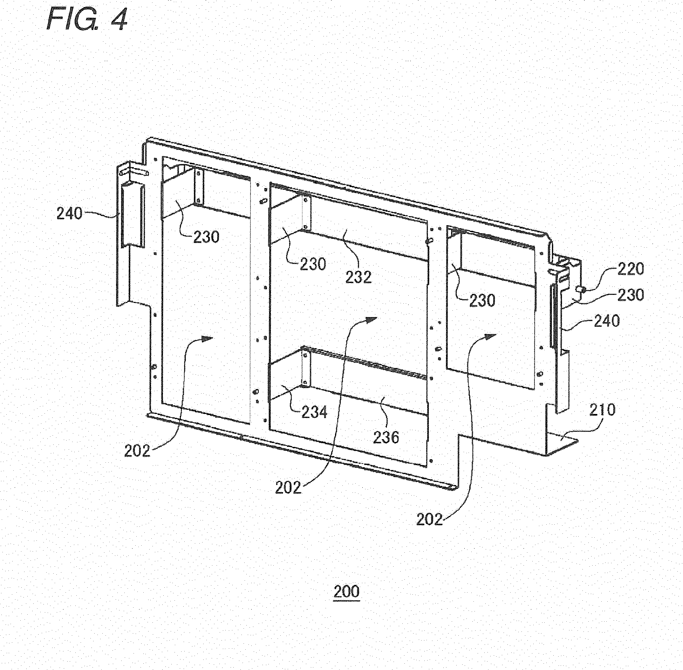

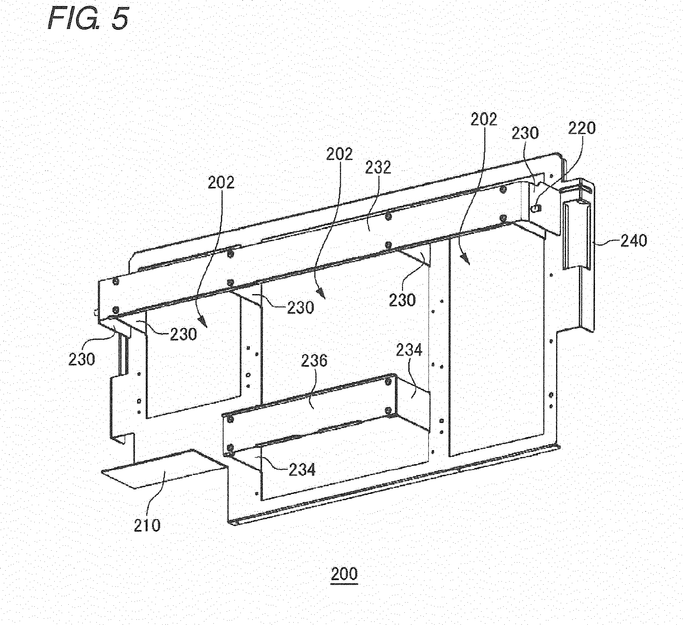

Fig. 4 is a perspective view obtained by viewing the fixing plate 200 provided for the power conditioner 10 from the front side. Fig. 5 is a perspective view obtained by viewing the fixing plate 200 from the back side. The fixing plate 200 has openings 202 in positions corresponding to the radiation fin portions 152 of the heat sink 150, respectively. When the fixing plate 200 is fixed to the back surface of the accommodation box 102, the radiation fin portions 152 are inserted into the openings 202, respectively and the radiation fin portions 152 are exposed through the openings 202, respectively.

On the back surface of the fixing plate 200, a plurality of pillar portions 230 are installed to stand up on both sides of each opening 202. A latching plate 232 is disposed between every two of the plurality of pillar portions 230. The latching plate 232 is supported by the plurality of pillar portions 230, and fixed to ends of the plurality of pillar portions 230. The latching plate 232 is latched to an attachment plate-side latching member of the attachment plate 300. The power conditioner 10 is attached to the attachment plate 300 in a manner that the latching plate 232 is latched to the attachment plate-side latching member.

On the back surface of the fixing plate 200, two pillar portions 234 stand up on both sides of the center opening 202. A Plate 236 which functions as a reinforcing plate for preventing deformation of the fixing plate 200 is fixed to the ends of the two pillar portions 234. The fixing plate 200 further includes a fixing plate-side eave plate 210 disposed above the insertion hole 110 formed in the accommodation box 102.

Guide pins 220 for guiding the latching plate 232 to the attachment plate-side latching member 330 are provided in external surfaces of the pillar portions 230 disposed on both sides of the power conditioner 10, among the plurality of pillar portions 230. The fixing plate 200 includes a bridge portion 240 serving as a strap which extends across the recessed portion 106 for hand's insertion in the accommodation box 102. The user can carry the power conditioner 10 by inserting his or her hand into the recessed portion 106 from the back side of the power conditioner 10 and grabbing the bridge portion 240.

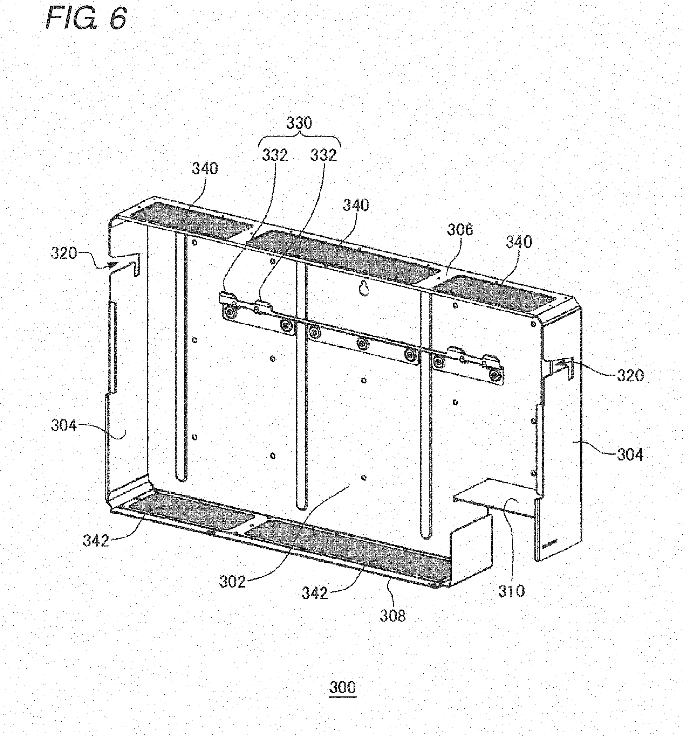

Fig. 6 is a perspective view obtained by viewing the attachment plate 300 provided for the power conditioner 10 from the front side. The attachment plate 300 includes a main plate 302 to be attached to an outer wall, etc. The attachment plate 300 has a side plate 304, a top plate 306, and a bottom plate 308 as sub plates. The main plate 302 is disposed in a position facing the back surface of the power conditioner 10. The side plate 304 is disposed in a position facing the side surface of the power conditioner 10. The top plate 306 is disposed in a position facing a top surface of the power conditioner 10. The bottom plate 308 is disposed in a position facing a bottom surface of the power conditioner 10. The top plate 306 and the bottom plate 308 have mesh portions 340 and 342, respectively, in positions facing the radiation fin portions 152. Since the top plate 306 and the bottom plate 308 are formed in a mesh shape, foreign substances can not reach the radiation fin portions 152.

The attachment plate 300 further includes an attachment plate-side latching member 330 provided in the main plate 302. The latching plate 232 which is the apparatus-side latching member provided in the fixing plate 200 is latched to the attachment plate-side latching member 330. The attachment plate-side latching member 330 includes a plurality of hook portions 332, and the latching plate 232 is latched to the plurality of hook portions 332.

The attachment plate 300 has a guide hole 320 serving as an attachment plate-side guide structure provided in the side plate 304. The guide hole 320 guides the apparatus-side latching member to the attachment plate-side latching member 330 by cooperating with the apparatus-side guide structure provided in the side surface of the power conditioner 10, when the power conditioner 10 is attached to the attachment plate 300. More specifically, the guide hole 320 guides the latching plate 232 to the attachment plate-side latching member 330 by cooperating with the guide pin 220 provided in the pillar portion 230 of the fixing plate 200. The latching plate 232 is provided in the back surface of the power conditioner 10. Therefore, when the power conditioner 10 is attached to the attachment plate 300, it is difficult for a user to see the latching plate 232. Therefore, it is difficult for a user to latch the latching plate 232 to the attachment plate-side latching member 330. Meanwhile, a user can easily attach the power conditioner 10 to the attachment plate 300 as the guide hole 320 and the guide pin 220 guide the latching plate 232 to the attachment plate-side latching member 330 by cooperating with each other.

The attachment plate 300 further icludes an attachment plate-side eave plate 310 disposed above the insertion hole 110 formed in the accommodation box 102. The attachment plate-side eave plate 310 is positioned such that the attachment plate-side eave plate 310 overlaps a fixing plate-side eave plate 210 of the fixing plate 200 when viewed in a vertical direction. The fixing plate-side eave plate 210 and the attachment plate-side eave plate stand to face each other and are disposed in a position at which they overlap each other when viewed in the vertical direction.

When only either one of the fixing plate 200 and the attachment plate 300 is provided with the eave plate, a gap may be formed between the end of the eave plate, and the other plate which is not provided with the eave plate. When such a gap exists, rain water which drops from the gap and passes by the radiation fin portion 152 of the heat sink 150 is likely to fall onto the cable disposed in the insertion hole 110. The rain water is likely to move along the cable and invade the casing 100 through the insertion hole 110.

On the other hand, when both of the fixing plate 200 and the attachment plate 300 are provided with respective eave plates, even if a gap exists between one eave plate of the two eave plates and one plate associated with the other eave plate, the other eave plate provided for the other plate can prevent the rain water from dropping from the gap to the cable. Therefore, with the configuration in which both of the fixing plate 200 and the attachment plate 300 are provided with respective eave plates, it is possible to prevent rain water from flowing along the cable and invading the casing 100 from the insertion hole 110.

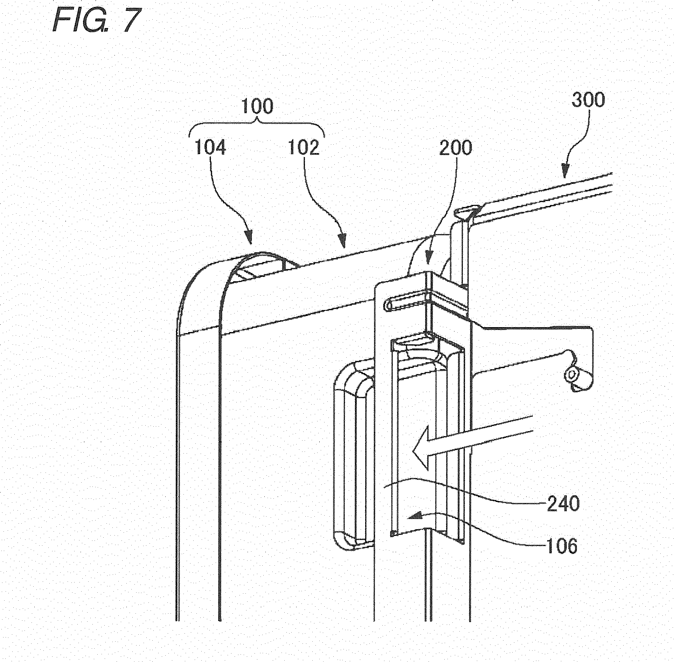

Fig. 7 is an enlarged perspective view obtained by viewing, from the back side, the recessed portion 106 for hand's insertion formed in the accommodation box 102 and the bridge portion 240 serving as a strap provided in the fixing plate 200. A user can grab the bridge portion 240 by inserting his or her hand into the recessed portion 106 in a direction indicated by an arrow illustrated in Fig. 7. In this way, the user can more stably carry the power conditioner 10 compared with a case where the power conditioner 10 is supported only by using the recessed portion 106. Since the fixing plate 200 can be made from a relatively hard material such as iron, when the power conditioner 10 is carried, deformation of the casing 100 can be prevented.

In the above embodiment, an example in which the female screw 204 is formed in the fixing plate 200 is described. However, the female screw may be formed in the casing 100. The female screw may be formed in each of the casing 100, the heat sink 150, and the fixing plate 200. Alternatively, through holes with no screw threads may be formed in the casing 100, the heat sink 150, and the fixing plate 200, and the heat sink 150 may be held using a bolt and a nut. The heat sink 150 may be a radiation plate which does not have the radiation fin portion 152.

In addition, in the above embodiment, an example in which the attachment plate-side latching member 330 has a hook is described. However, other structures may be possible as long as the attachment plate-side latching member 330 and the fixing plate-side latching member are latched to each other. For example, the latching plate 232 which is the fixing plate-side latching member may have a hook, and the attachment plate-side latching member 330 may have an attachment hole into which the hook is hooked.

Although the present invention has been described using the embodiments, the technical scope of the present invention is not limited to the scope given in the above-described embodiments. It is apparent to a person skilled in the art that various changes and alterations to embodiments can be made. It is apparent that embodiments obtained by changing or altering the above-described embodiments may also fall within the technical scope of the invention.

It should be noted that operations, sequences, steps, execution order of the steps in a device, a system, a program, and a method stated in claims, description, and drawings are arbitrarily performed as long as expressions such as "before that" or "previously" are not explicitly stated and when an output of a preceding step is used in a subsequent step. Although a description is made using expressions such as "first of all" or "next" for convenience in the claims, description, and drawings, it does not mean that it is indispensable to perform in that order.

## Claims

1. An apparatus comprising:
a casing (100);
a heat sink (150) configured to radiate heat emitted from the casing (100); and
a fixing plate (200) configured to fix the heat sink (150) by holding the heat sink (150) between the fixing plate (200) and the casing (100).

2. The apparatus according to claim 1, wherein
the heat sink (150) comprises a radiation fin portion (152) and a fixed portion (154), and
the fixing plate (200) is configured to fix the heat sink (150) by holding the fixed portion (154) between the fixing plate (200) and the casing (100).

3. The apparatus according to claim 1 or 2, wherein
the fixing plate (200) has an opening (202) through which a portion of the heat sink (150) is exposed.

4. The apparatus according to claim 1, wherein
the heat sink (150) comprises a radiation fin portion (152) and a fixed portion (154),
the fixing plate (200) has an opening (202) through which a portion of the heat sink (150) is exposed,
the fixing plate (200) is configured to fix the heat sink (150) by holding the fixed portion (154) between the casing (100) and the fixing plate (200), and
the radiation fin portion (152) is configured to protrude outward through the opening (202).

5. The apparatus according to any one of claims 1 to 4, wherein
the heat sink (150) has a first through hole (156), and
the heat sink (150) is held between the casing (100) and the fixing plate (200) by a screw member which is inserted into the first through hole (156).

6. The apparatus according to claim 5, wherein
the casing (100) has a second through hole (120),
the fixing plate (200) has a female screw (204), and
the heat sink (150) is held between the casing (100) and the fixing plate (200) in a manner that a male screw which is the screw member is screwed into the female screw (204), the male screw passing through the second through hole (120) and the first through hole (156) from inside of the casing (100).

7. The apparatus according to any one of claims 1 to 6, wherein
the heat sink (150) is provided on a back surface (114) of the casing (100),
the casing (100) comprises a recessed portion (106) in a corner (113) between the back surface (114) and a side surface (112) adjacent to the back surface (114), and
the fixing plate (200) comprises a bridge portion (240) which extends across the recessed portion (106).

8. The apparatus according to any one of claims 1 to 7, wherein
the fixing plate (200) comprises an apparatus-side latching member latched to an attachment plate (300) disposed on a back surface side of the apparatus, and
the apparatus is attached to the attachment plate (300) in a manner that the apparatus-side latching member is latched to an attachment plate-side latching member (330) provided in the attachment plate (300).

9. The apparatus according to claim 8, wherein
the fixing plate (200) further comprises a pillar portion (230) which stands on the back surface side of the apparatus,
the apparatus-side latching member comprises a latching plate (232) supported by the pillar portion (230), and
the latching plate (232) is latched to the attachment plate-side latching member (330).

10. The apparatus according to claim 9, wherein
the pillar portion (230) comprises a plurality of pillar plates, and the latching plate (232) is supported by the plurality of pillar plates.

11. The apparatus according to any of claims 1 to 10, wherein
the fixing plate (200) is made from a harder material than the heat sink (150).
